# EUROPEAN PATENT APPLICATION

(11) **EP 4 716 406 A1**
(43) Date of publication of application: **25.03.2026**
(21) Application number: 24218557.7
(22) Date of filing: 10.12.2024
(51) Int. Cl.: H10D 30/47, H10D 62/10, H01L 23/522, H10D 8/60, H10D 62/17, H10D 62/85

(54) **SEMICONDUCTOR DEVICE**

(30) Priority: 24.09.2024 TW 113136235
(71) Applicant: Hon Hai Precision Industry Co., Ltd., 236038 New Taipei City (TW)
(72) Inventor: CHANG, Jhe-Hao, 300093 Hsinchu City (TW); YOU, Jheng-Sheng, 300093 Hsinchu City (TW)
(74) Representative: Winter, Brandl - Partnerschaft mbB

(57) **Abstract**

A semiconductor device includes a substrate structure (100), a source structure (110), a drain structure (120), and a gate structure (130). The source structure, the drain structure, and the gate structure are over the substrate structure and are arranged along a first direction (D1). The drain structure includes a plurality of first island structures (121) and a plurality of second island structures (122) arranged alternately and spaced apart along a second direction (D2). The second direction is substantially perpendicular to the first direction. Each of the first island structures includes a p-type semiconductor layer (121a) and a first metal electrode (121b) over the p-type semiconductor layer. Each of the second island structures (122) includes a second metal electrode (122a). In a conducting state, a potential of the first metal electrode of each of the first island structures is different from a potential of the second metal electrode of each of the second island structures.

## Description

### BACKGROUND

### Technical Field

The present disclosure relates to a semiconductor device.

### Description of Related Art

III-V compound semiconductors are widely used in integrated circuit components, such as high power field-effect transistors (FET), high frequency transistors, high electron mobility transistors (HEMT), or the like, due to their semiconductor properties. Among high electron mobility transistors, gallium nitride-based materials have received special attention in recent years due to their wide band gap, high saturation rate, and suitability for high frequency and high power density operations. However, in order to cope with the increase in integration density, it is necessary to further reduce the energy consumption and on-state resistance of high electron mobility transistors.

### SUMMARY

According to an embodiment of the disclosure, a semiconductor device includes a substrate structure, a source structure, a drain structure, and a gate structure. The substrate structure includes a semiconductor layer. The source structure, the drain structure, and the gate structure are over the semiconductor layer and arranged along a first direction. The drain structure includes a plurality of first island structures and a plurality of second island structures. Each of the first island structures includes a p-type semiconductor layer and a first metal electrode over the p-type semiconductor layer. Each of the second island structures includes a second metal electrode. The first island structures and the second island structures are arranged alternately and spaced apart along a second direction. The second direction is substantially perpendicular to the first direction. In a conducting state, a potential of the first metal electrode of each of the first island structures is different from a potential of the second metal electrode of each of the second island structures. The gate structure is between the source structure and the drain structure.

According to another embodiment of the disclosure, a semiconductor device includes a substrate structure, a source structure, a drain structure, and a gate structure. The substrate structure includes a semiconductor layer. The source structure, the drain structure, and the gate structure are over the semiconductor layer and arranged along a first direction. The drain structure includes a drain metal, a plurality of first island structures, and a plurality of second island structures. Each of the first island structures includes a p-type semiconductor layer and at least one first drain via over the p-type semiconductor layer. The at least one first drain via is in contact with the p-type semiconductor layer and connected to the drain metal. Each of the second island structures includes a metal electrode and at least one second drain via over the metal electrode. The at least one second drain via is in contact with the metal electrode and connected to the drain metal. The first island structures and the second island structures are arranged alternately and spaced apart along a second direction. The second direction is substantially perpendicular to the first direction. In a conducting state, a potential of at least one contact surface between the at least one first drain via and the p-type semiconductor layer of each of the first island structures is different from a potential of the metal electrode of each of the second island structures. The gate structure is between the source structure and the drain structure.

### BRIEF DESCRIPTION OF THE DRAWINGS

FIG. 1 is a top view of a semiconductor device according to one embodiment of this disclosure;
FIG. 2, FIG. 3, and FIG. 4 are partial cross-sectional views of a semiconductor device according to one embodiment of this disclosure;
FIG. 5 is a schematic diagram of an equivalent circuit model of a semiconductor device according to one embodiment of this disclosure;
FIG. 6 is a partial cross-sectional view of a semiconductor device according to another embodiment of this disclosure; and
FIG. 7 is a top view of a semiconductor device according to still another embodiment of this disclosure.

### DETAILED DESCRIPTION

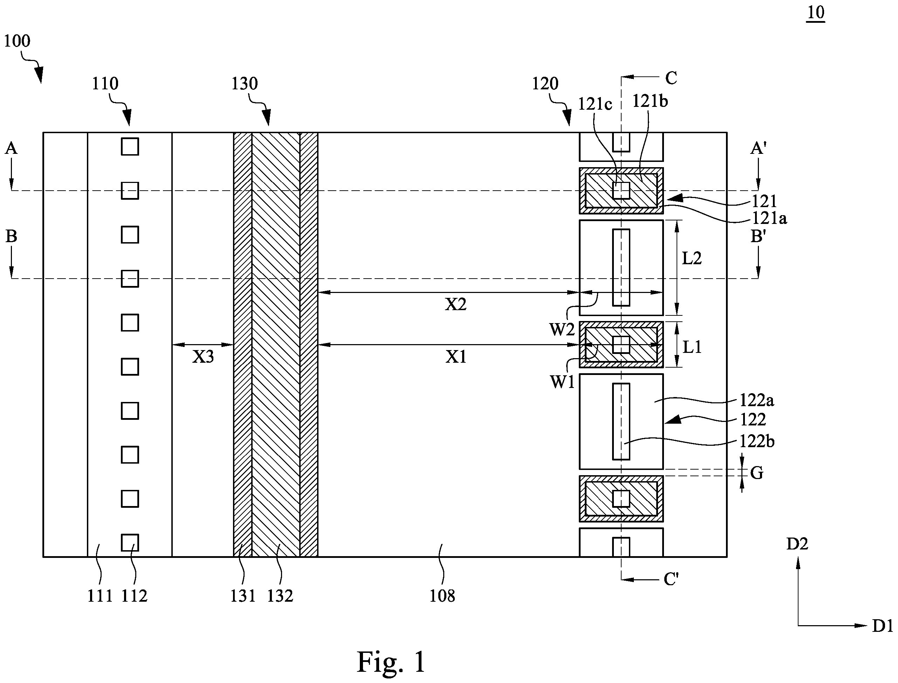

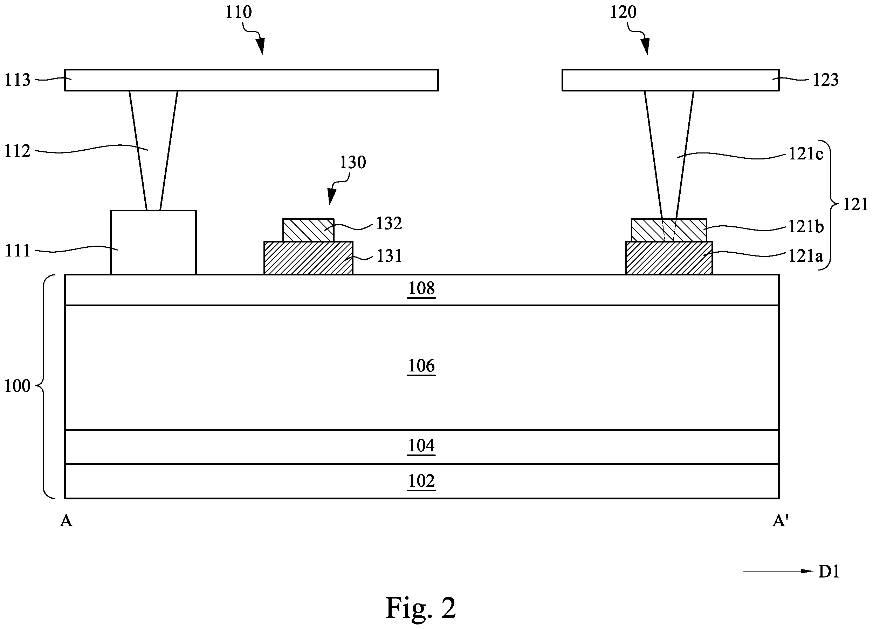

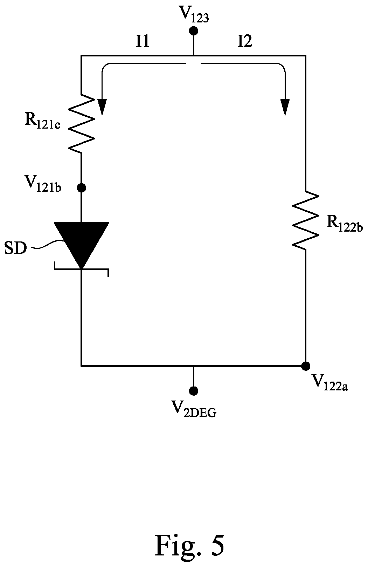

FIG. 1 is a top view of a semiconductor device 10 according to one embodiment of this disclosure. FIG. 2, FIG. 3, and FIG. 4 are partial cross-sectional views of the semiconductor device 10 taken along a line A-A', a line B-B', and a line C-C' in FIG. 1, respectively. FIG. 5 is a schematic diagram of an equivalent circuit model of the semiconductor device 10.

As shown in FIG. 1, the semiconductor device 10 includes a substrate structure 100, a source structure 110, a drain structure 120, and a gate structure 130. Specifically, the source structure 110, the drain structure 120, and the gate structure 130 are over a semiconductor layer 108 of the substrate structure 100 and arranged along a direction D1. The gate structure 130 is between the source structure 110 and the drain structure 120. The source structure 110 and the gate structure 130 extend along a direction D2. As shown in FIG. 1, the direction D1 is substantially perpendicular to a direction of the gate width, and the direction D2 is substantially parallel to the direction of the gate width.

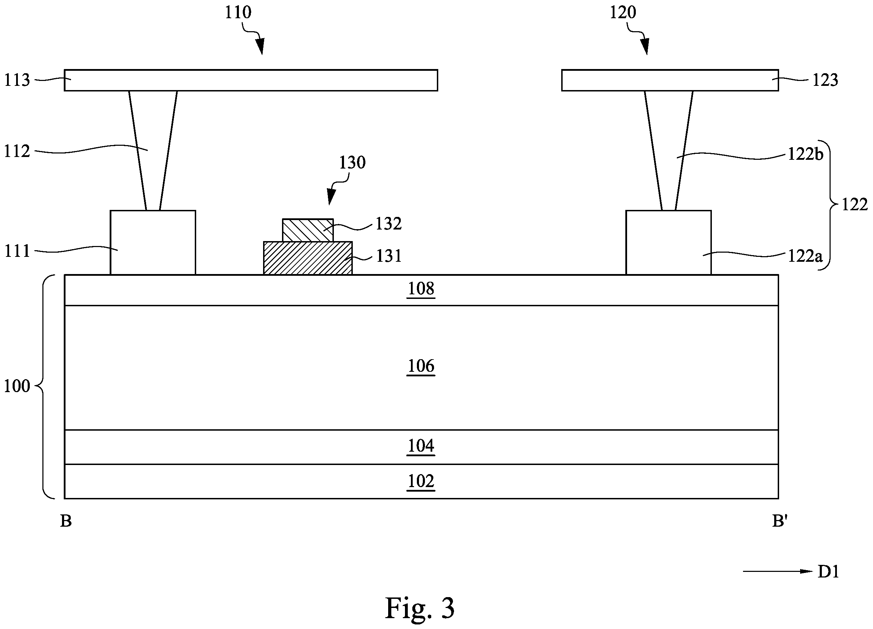

The substrate structure 100 includes a semiconductor stack structure. For example, as shown in FIG. 2 and FIG. 3, the substrate structure 100 includes a substrate 102, a buffer layer 104, a semiconductor layer 106, and a semiconductor layer 108. The buffer layer 104 is over the substrate 102. The semiconductor layer 106 is over the buffer layer 104. The semiconductor layer 108 is over the semiconductor layer 106. In some embodiments, the semiconductor layer 106 and the semiconductor layer 108 include III-V compound semiconductors. For example, the semiconductor layer 106 may include gallium nitride (GaN). The semiconductor layer 108 may include aluminum gallium nitride (AlGaN). As such, the semiconductor layer 106 and the semiconductor layer 108 form a heterojunction interface, which is characterized in a high density two-dimensional electron gas (2DEG) layer. Therefore, the semiconductor device 10 has lower energy consumption and higher power density than silicon-based semiconductor devices.

The source structure 110 includes a source electrode 111, multiple source vias 112, and a source metal 113. As shown in FIG. 1, the source electrode 111 is a strip-shaped material extending along the direction D2. The source vias 112 are over the source electrode 111 and arranged along the direction D2. As shown in FIG. 2 and FIG. 3, the source metal 113 is over the source electrode 111 and electrically connected to the source electrode 111 through the source vias 112. The materials of the source electrode 111 and the source metal 113 may include, but are not limited to, titanium, titanium nitride, aluminum, copper, or combinations thereof.

The drain structure 120 includes multiple first island structures 121, multiple second island structures 122, and a drain metal 123. As shown in FIG. 1, the first island structures 121 and the second island structures 122 are alternately arranged along the direction D2. There is a gap G between one of the first island structures 121 and one of the second island structures 122 that is adjacent to the one of the first island structures 121. Detailed features of the first island structures 121 and the second island structures 122 will be described in subsequent paragraphs.

The gate structure 130 includes a gate semiconductor layer 131 and a gate metal electrode 132. As shown in FIG. 1, the gate semiconductor layer 131 and the gate metal electrode 132 are strip-shaped materials extending along the direction D2. As shown in FIG. 2 and FIG. 3, the gate metal electrode 132 is over the gate semiconductor layer 131. The gate semiconductor layer 131 may include, but is not limited to, gallium nitride or p-type doped gallium nitride. The gate metal electrode 132 may include, but is not limited to, titanium, titanium nitride, aluminum, copper, or combinations thereof.

As shown in FIG. 2, each of the first island structures 121 includes a p-type semiconductor layer 121a, a metal electrode 121b over the p-type semiconductor layer 121a, and a drain via 121c over the metal electrode 121b. In some embodiments, the p-type semiconductor layer 121a is made of gallium nitride with p-type dopants. The metal electrode 121b may include, but is not limited to, titanium, titanium nitride, aluminum, copper, or combinations thereof. The metal electrode 121b is in contact with a top surface of the p-type semiconductor layer 121a to form a Schottky barrier diode (SBD). A bottom surface of the p-type semiconductor layer 121a is in contact with the semiconductor layer 108. The metal electrode 121b and the p-type semiconductor layer 121a are electrically connected to the drain metal 123 through the drain via 121c. In some embodiments, the metal electrode 121b may be omitted, and the drain via 121c is directly disposed on the p-type semiconductor layer 121a along the dotted line in FIG. 2 and in contact with the top surface of the p-type semiconductor layer 121a. As such, the drain via 121c and the p-type semiconductor layer 121a form a Schottky barrier diode.

As shown in FIG. 3, each of the second island structures 122 includes a metal electrode 122a and a drain via 122b over the metal electrode 122a. The metal electrode 122a is in contact with the semiconductor layer 108 to form an ohmic contact. The metal electrode 122a may include, but is not limited to, titanium, titanium nitride, aluminum, copper, or combinations thereof. The metal electrode 122a is electrically connected to the drain metal 123 through the drain via 122b.

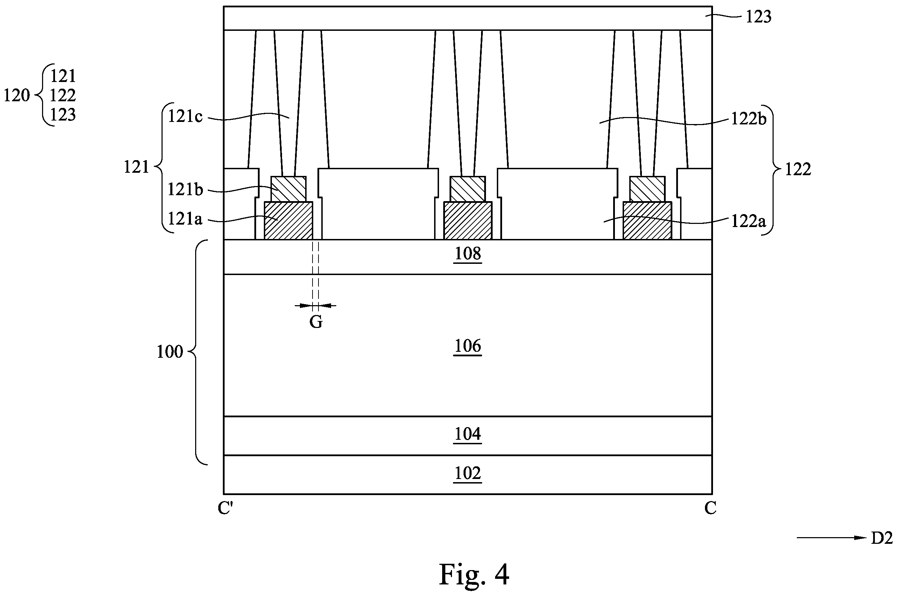

As shown in FIG. 4, the first island structures 121 and the second island structures 122 are arranged alternately, spaced apart along the direction D2, and connected to the drain metal 123. In the cross-sectional view taken along the line C-C', the metal electrode 122a has a lower portion and an upper portion connected to the lower portion. The lower portion of the metal electrode 122a is in direct contact with the semiconductor layer 108. The upper portion of the metal electrode 122a is over the lower portion and in contact with the drain via 122b. There is a gap G between an edge of the upper portion of the metal electrode 122a and an edge of the p-type semiconductor layer 121a. In other words, an orthographic projection area of the metal electrode 122a of each of the second island structures 122 projected onto the substrate structure 100 and an orthographic projection area of the p-type semiconductor layer 121a of each of the first island structures 121 projected onto the substrate structure 100 are separated from each other and do not overlap. In some embodiments, as shown in FIG. 4, a top surface of the upper portion of the metal electrode 122a is higher than a top surface of the metal electrode 121b. That is, a bottom end of the drain via 122b is higher than a bottom end of the drain via 121c.

In such configuration, the first island structures 121 and the second island structures 122 are spaced apart and electrically connected to the drain metal 123 via the drain vias 121c and the drain vias 122b, respectively. As a result, in a conducting state, the metal electrode 121b of each of the first island structures 121 and the metal electrode 122a of each of the second island structures 122 may have different potentials. Specifically, referring to FIG. 5, current may flow from the drain metal 123, which has a potential value V₁₂₃, to the two-dimensional electron gas layer, which has a potential value V_{2DEG}, via two paths. The path shown on the left of FIG. 5 passes through the drain via 121c and the Schottky barrier diode SD formed by the metal electrode 121b and the p-type semiconductor layer 121a. The path shown on the right of FIG. 5 passes through the drain via 122b and the metal electrode 122a. Therefore, a potential value V_{121b} of the metal electrode 121b and a potential value V₁₂₂ₐ of the metal electrode 122a may be different. The features of the first island structures 121 and the second island structures 122 can be adjusted such that the drain via 121c of each of the first island structures 121 has a resistance value R_{121c} that is greater than a resistance value R_{122b} of the drain via 122b of each of the second island structures 122. In this way, a current value I1 of current flowing through the path on the left is less than a current value I2 of current flowing through the path on the right. Hence, the energy consumption of each of the first island structures 121 may be reduced. In addition, the drain via 121c serves as a protection resistor that may suppress voltage overshoot caused by abnormal disturbance of the drain metal 123 and avoid damage to the Schottky barrier diode SD. Moreover, in embodiments where the metal electrode 121b is omitted, a potential of a contact surface between the drain via 121c and the p-type semiconductor layer 121a may be different from a potential of the metal electrode 122a to achieve the intended purpose.

Reference is made to FIG. 1 and FIG. 4 again. In order to achieve the foregoing purpose, the features of the first island structures 121 and the second island structures 122 may be elaborated.

As shown in FIG. 1, a contact area between the drain via 121c and the metal electrode 121b (i.e., a bottom area of the drain via 121c) may be less than a contact area between the drain via 122b and the metal electrode 122a (i.e., a bottom area of the drain via 122b). As such, the resistance value of the drain via 121c is greater than the resistance value of the drain via 122b. In embodiments where the metal electrode 121b is omitted, a contact area between the drain via 121c and the p-type semiconductor layer 121a is set to be less than the contact area between the drain via 122b and the metal electrode 122a to achieve a similar effect. Similarly, as shown in FIG. 4, in some embodiments, a cross-sectional area of the drain via 121c is less than a cross-sectional area of the drain via 122b. In some embodiments, a height of the drain via 121c may be greater than a height of the drain via 122b.

On the other hand, as shown in FIG. 1, in some embodiments, a width W1 of each of the first island structures 121 along the direction D1 is substantially equal to a width W2 of each of the second island structures 122 along the direction D1. For example, the width W1 is between about 0.1 µm and about 3 µm. The width W2 is between about 0.1 µm and about 3 µm. In some embodiments, a length L1 of each of the first island structures 121 along the direction D2 is less than a length L2 of each of the second island structures 122 along the direction D2. For example, the length L1 is between about 0.1 µm and about 3 µm. The length L2 is between about 0.1 µm and about 30 µm. As such, an area of each of the second island structures 122 in a top view is increased, thereby reducing its on-state resistance. In this case, in the top view, the area of each of the second island structures 122 is greater than an area of each of the first island structures 121.

Similarly, as shown in FIG. 4, a contact area between each of the second island structures 122 and the semiconductor layer 108 can be increased to reduce contact resistance. As such, the contact area between each of the second island structures 122 and the semiconductor layer 108 (i.e., a bottom area of each of the second island structures 122) is greater than a contact area between each of the first island structures 121 and the semiconductor layer 108 (i.e., a bottom area of each of the first island structures 121).

In some embodiments, as shown in FIG. 1, an edge of each of the first island structures 121 may be flush with an edge of each of the second island structures 122. Specifically, an edge of the p-type semiconductor layer 121a of each of the first island structures 121 is flush with an edge of the metal electrode 122a of each of the second island structures 122. Thus, the gate-drain length (L_{gd}, which is equivalent to a distance X1 and a distance X2 shown in FIG. 1) may be maximized, thereby reducing electric field spikes, providing a greater breakdown voltage, and improving device reliability. As such, since the first island structures 121 and the second island structures 122 are flush and aligned along the direction D2, the distance X1 between the p-type semiconductor layer 121a and the gate semiconductor layer 131 along the direction D1 is substantially equal to the distance X2 between the metal electrode 122a and the gate semiconductor layer 131 along the direction D1. It should be noted that both the distance X1 and the distance X2 are greater than a distance X3 between the source structure 110 and the gate structure 130. For example, the distance X1 is between about 0.3 µm and about 30 µm. The distance X2 is between about 0.3 µm and about 30 µm. The distance X3 is between about 0.1 µm and about 1 µm.

In some embodiments, the distance X1 is substantially equal to the distance X2. The width W1 is substantially equal to the width W2. Thus, a central axis of each of the first island structures 121 coincides with a central axis of each of the second island structures 122 and is parallel to the direction D2. For example, the central axes of the first island structures 121 and the central axes of the second island structures 122 coincide with the line C-C'.

Next, a method for forming the semiconductor device 10 according to one embodiment of this disclosure will be described accompanied with FIG. 1 and FIG. 4. First, the substrate structure 100 is provided. For example, the buffer layer 104, the semiconductor layer 106, and the semiconductor layer 108 are sequentially formed on the substrate 102. Next, the p-type semiconductor layers 121a are formed separated from each other and arranged along the direction D2. In some embodiments, the gate semiconductor layer 131 may be formed simultaneously in this step. Next, the metal electrodes 121b are formed over the p-type semiconductor layers 121a. In some embodiments, the gate metal electrode 132 may be formed simultaneously in this step. Next, the metal electrodes 122a are formed between every two adjacent ones of the p-type semiconductor layers 121a, so that the p-type semiconductor layers 121a and the metal electrodes 122a are arranged alternately and spaced apart along the direction D2. In some embodiments, the source electrode 111 may be formed simultaneously in this step. Next, the drain vias 121c and the drain vias 122b are formed over the metal electrodes 121b and the metal electrodes 122a, respectively. In some embodiments, the source vias 112 may be formed simultaneously over the source electrode 111 in this step. Next, the drain metal 123 is formed over the drain vias 121c and the drain vias 122b. In some embodiments, the source metal 113 may be formed over the source vias 112 simultaneously in this step.

In embodiments where the metal electrodes 121b are omitted, the method does not include forming the metal electrodes 121b over the p-type semiconductor layers 121a. Instead, in the step of forming the drain vias 121c, the drain vias 121c are formed directly on the p-type semiconductor layers 121a.

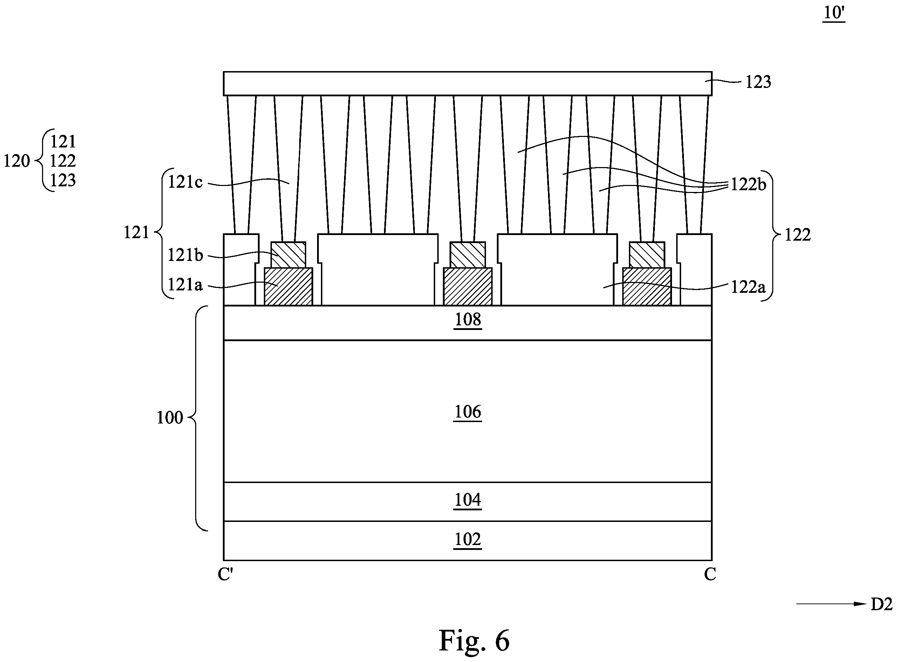

In some embodiments, there may be multiple drain vias 121c over one metal electrode 121b and multiple drain vias 122b over one metal electrode 122a. For example, reference is made to FIG. 6, which illustrates a partial cross-sectional view of a semiconductor device 10' according to another embodiment of this disclosure. The difference between the semiconductor device 10' and the semiconductor device 10 is that the semiconductor device 10' includes three drain vias 122b separated and arranged along the direction D2 over the metal electrode 122a of each of the second island structures 122. Each of the drain vias 122b is approximately the same size as the drain via 121c. In such embodiments, a total contact area of the drain vias 122b over each of the second island structures 122 is greater than a total contact area of the drain via 121c over each of the first island structures 121, such that a total resistance value of the drain via 121c over each of the first island structures 121 is greater than a total resistance value of the drain vias 122b over each of the second island structures 122.

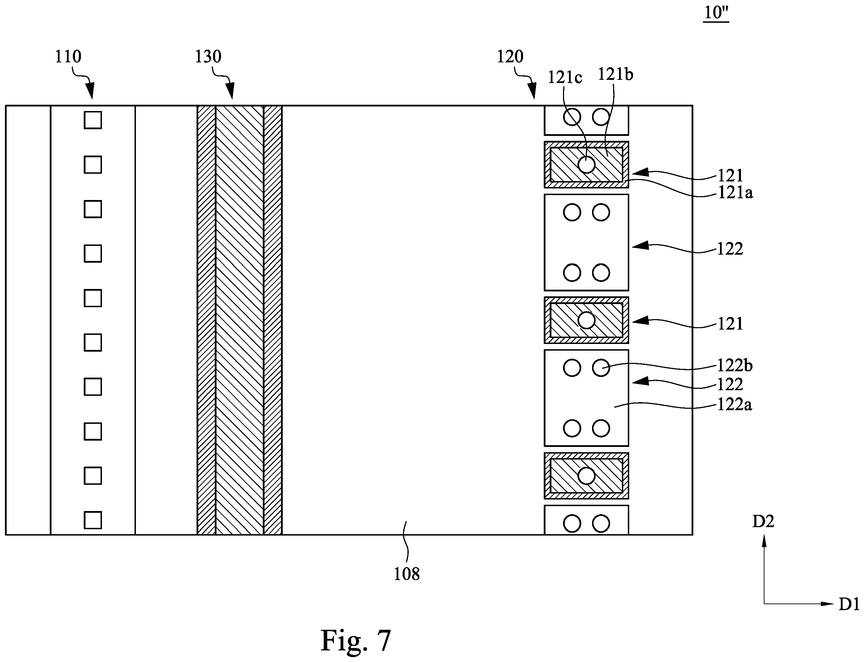

In some embodiments, the drain vias 121c and the drain vias 122b may have any shape. For example, reference is made to FIG. 7, which is a top view of a semiconductor device 10" according to still another embodiment of this disclosure. The difference between the semiconductor device 10" and the semiconductor device 10 is that the drain vias 121c and the drain vias 122b of the semiconductor device 10" have a circular profile in the top view. Also, in such embodiments, there are four drain vias 122b distributed over the metal electrode 122a of each of the second island structures 122. Similarly, the total contact area of the drain vias 122b over each of the second island structures 122 is greater than the total contact area of the drain via 121c over each of the first island structures 121, so that the total resistance value of the drain via 121c over each of the first island structures 121 is greater than the total resistance value of the drain vias 122b over each of the second island structures 122.

According to the foregoing recitations of the embodiments of the disclosure, it may be seen that in some embodiments of the semiconductor device of this disclosure, the first island structures and the second island structures of the drain structure are arranged alternately and spaced apart. Each of the first island structures includes the metal electrode and the p-type semiconductor layer that form a Schottky barrier diode. Each of the second island structures includes the metal electrode that forms an ohmic contact with the underlying semiconductor layer. In addition, the first island structures and the second island structures are electrically connected to the drain metal through different drain vias, respectively. In this way, in the conducting state, the metal electrode of each of the first island structures and the metal electrode of each of the second island structures have different potentials. In turn, energy consumption may be further reduced by modifying the relationship of areas of the drain vias and the metal electrodes of the first and second island structures, and damage caused by voltage overshoot may be suppressed.

## Claims

1. A semiconductor device (10, 10', 10"), comprising:
a substrate structure (100) comprising a semiconductor layer (108);
a source structure (110) over the semiconductor layer (108) of the substrate structure (100);
a drain structure (120) over the semiconductor layer (108) and arranged along a first direction (D1) with the source structure (110), wherein the drain structure (120) comprises:
a plurality of first island structures (121), wherein each of the first island structures (121) comprises a p-type semiconductor layer (121a) and a first metal electrode (121b) over the p-type semiconductor layer (121a); and
a plurality of second island structures (122), wherein each of the second island structures (122) comprises a second metal electrode (122a),
wherein the first island structures (121) and the second island structures (122) are arranged alternately and spaced apart along a second direction (D2), and the second direction (D2) is substantially perpendicular to the first direction (D1),
wherein in a conducting state, a potential of the first metal electrode (121b) of each of the first island structures (121) is different from a potential of the second metal electrode (122a) of each of the second island structures (122); and
a gate structure (130) over the semiconductor layer (108) and between the source structure (110) and the drain structure (120).

2. The semiconductor device (10, 10', 10") of claim 1, wherein the drain structure (120) further comprises a drain metal (123), each of the first island structures (121) further comprises at least one first drain via (121c) over the first metal electrode (121b) and electrically connected to the drain metal (123), and each of the second island structures (122) further comprises at least one second drain via (122b) over the second metal electrode (122a) and electrically connected to the drain metal (123).

3. The semiconductor device (10, 10', 10") of claim 2, wherein a total contact area between the at least one first drain via (121c) and the first metal electrode (121b) is less than a total contact area between the at least one second drain via (122b) and the second metal electrode (122a).

4. The semiconductor device (10, 10', 10") of claim 1, wherein a contact area between each of the second island structures (122) and the semiconductor layer (108) is greater than a contact area between each of the first island structures (121) and the semiconductor layer (108).

5. The semiconductor device (10, 10', 10") of claim 1, wherein an edge of each of the first island structures (121) is flush with an edge of each of the second island structures (122).

6. The semiconductor device (10, 10', 10") of claim 1, wherein a width (W1) of each of the first island structures (121) along the first direction (D1) is substantially equal to a width (W2) of each of the second island structures (122) along the first direction (D1).

7. A semiconductor device (10), comprising:
a substrate structure (100) comprising a semiconductor layer (108);
a source structure (110) over the semiconductor layer (108) of the substrate structure (100);
a drain structure (120) over the semiconductor layer (108) and arranged along a first direction (D1) with the source structure (110), wherein the drain structure (120) comprises:
a drain metal (123);
a plurality of first island structures (121), wherein each of the first island structures (121) comprises a p-type semiconductor layer (121a) and at least one first drain via (121c) over the p-type semiconductor layer (121a), and the at least one first drain via (121c) is in contact with the p-type semiconductor layer (121a) and connected to the drain metal (123); and
a plurality of second island structures (122), wherein each of the second island structures (122) comprises a metal electrode (122a) and at least one second drain via (122b) over the metal electrode (122a), and the at least one second drain via (122b) is in contact with the metal electrode (122a) and connected to the drain metal (123),
wherein the first island structures (121) and the second island structures (122) are arranged alternately and spaced apart along a second direction (D2), and the second direction (D2) is substantially perpendicular to the first direction (D1),
wherein in a conducting state, a potential of at least one contact surface between the at least one first drain via (121c) and the p-type semiconductor layer (121a) of each of the first island structures (121) is different from a potential of the metal electrode (122a) of each of the second island structures (122); and
a gate structure (130) over the semiconductor layer (108) and between the source structure (110) and the drain structure (120).

8. The semiconductor device (10) of claim 7, wherein a total area of the at least one contact surface between the at least one first drain via (121c) and the p-type semiconductor layer (121a) is less than a total area of at least one contact surface between the at least one second drain via (122b) and the metal electrode (122a).

9. The semiconductor device (10) of claim 7, wherein a width (W1) of each of the first island structures (121) along the first direction (D1) is substantially equal to a width (W2) of each of the second island structures (122) along the first direction (D1).

10. The semiconductor device (10) of claim 7, wherein a central axis of each of the first island structures (121) coincides with a central axis of each of the second island structures (122) and is parallel to the second direction (D2).
